Europäisches Patentamt

European Patent Office

Office européen des brevets

(19)

(11) **EP 0 878 838 B1**

(12) **FASCICULE DE BREVET EUROPEEN**

(45) Date de publication et mention
de la délivrance du brevet:
**16.03.2005 Bulletin 2005/11**

(51) Int Cl.⁷: **H01L 21/3213**, H01L 21/3105,
C09G 1/02, C09K 3/14

(21) Numéro de dépôt: **98400715.3**

(22) Date de dépôt: **26.03.1998**

(54) **Nouveau procédé de polissage mécanochimique de couches de matériaux semiconducteurs ou isolants**

Verfahren zum chemisch-mechanischen Polieren von halbleitenden oder isolierenden Schichten

Process for chemical-mechanical polishing of semiconductor or insulating layers

(84) Etats contractants désignés:
**AT BE CH DE DK ES FI FR GB IE IT LI LU MC NL SE**

(30) Priorité: **07.04.1997 FR 9704207**

(43) Date de publication de la demande:
**18.11.1998 Bulletin 1998/47**

(60) Demande divisionnaire:
**01101577.3 / 1 111 023**

(73) Titulaire: **Clariant Finance (BVI) Limited Road Town, Tortola (VG)**

(72) Inventeurs:
• **Jacquinot, Eric**
**60350 Trosly Breuil (FR)**
• **Rivoire, Maurice**
**38240 Meylan (FR)**
• **Euvrard, Catherine**
**38400 Saint Martin D'Heres (FR)**

(74) Mandataire: **D'haemer, Jan Constant et al**
**Clariant International Ltd.,**
**Rothausstrasse 61**
**4132 Muttenz 1 (CH)**

(56) Documents cités:
**EP-A- 0 363 100          EP-A- 0 684 638**
**EP-B- 0 812 803          WO-A-98/13218**
**US-A- 3 170 273          US-A- 3 867 304**
**US-A- 4 435 247          US-A- 4 664 679**

• **SUGIMOTO F ET AL: "A PH CONTROLLED CHEMICAL MECHANICAL POLISHING METHOD FOR ULTRA -THINBONDED SOI WAFER" DIGEST OF TECHNICAL PAPERS OF THE SYMPOSIUM ON VLSI TECHNOLOGY, KYOTO, MAY 17 - 19, 1993,17 mai 1993, page 113/114 XP000462930 INSTITUTE OF ELECTRICAL AND ELECTRONICS ENGINEERS**
• **"Ullmann's Encyclopedia of Industrial Chemistry, 5th edition, vol. A23, pp 614-620"**
• **"Kirk-Othmer : Encyclopedia of chemical technology, 4th edition, vol. 21"**
• **"K K Iler : The colloid chemistry of silica, 1994, pp 51-66"**
• **Technical brochure Degussa : Pyrogene Kieselsäure**

## Description

La présente invention concerne un nouveau procédé de polissage mécano-chimique de matériaux semi-conducteurs ou isolants utilisés lors de la fabrication des circuits intégrés.

L'élaboration des circuits intégrés fait appel à deux métiers successifs, distincts l'un de l'autre.

Un premier métier consiste en la fabrication de plaques pour circuits intégrés, c'est-à-dire la fabrication de tranches de silicium. C'est ainsi que dans ce type d'industrie, on fait croître un cristal de silicium, que l'on coupe ensuite en plaques d'environ 750 micromètres d'épaisseur, qui sont alors soumises à un polissage de manière à obtenir une plaque de silicium vierge poli. Ce type d'industrie ne fabrique par contre pas de circuits intégrés et ces plaques pour circuits intégrés sont vendues à des fabriquants de circuits intégrés.

US-A-3.170.273, US-A-4.664.679, US-A-4.117.093 et EP-A-0.684.638 décrivent le polissage des plaques initiales de silicium obtenues à partir de la pleine barre de cristal que l'on découpe pour obtenir des plaques pour circuits intégrés.

Le deuxième métier, celui des fabriquants de circuits intégrés, consiste à réaliser ensuite les circuits intégrés, à partir des plaques pour circuits intégrés obtenues auprès des industriels précédemment cités. La réalisation des circuits intégrés implique en particulier les étapes suivantes :

Tout d'abord, la totalité de la surface des plaques pour circuits intégrés est oxydée pour obtenir une couche isolante. On procède alors à une photolithographie de la couche d'oxyde pour graver cette dernière de manière à accéder au silicium. Les zones ainsi gravées en creux sont appelées zones actives. Aux emplacements de ces zones actives, on procède à une nouvelle oxydation dite "oxydation de grille". On place alors une couche par exemple de polysilicium dopé qui constitue la grille. On dépose ensuite un isolant, et on procède à une nouvelle photolithographie pour retrouver à nouveau le niveau de la tranche de silicium d'origine. Dans ces emplacements, on fait alors un dépôt d'un métal tel le tungstène. La présente invention concerne le polissage à ce niveau d'élaboration des circuits intégrés, ainsi qu'aux niveaux d'élaboration ultérieurs. En effet, on peut réaliser actuellement jusqu'à 6 niveaux de contact impliquant à chaque niveau une gravure en creux munie de dépôts, puis remise à flot par une opération de polissage du métal et de l'isolant, selon la présente invention. La présente invention ne concerne par contre pas le polissage primaire des plaques pour circuits intégrés.

Comme on l'a vu ci-dessus, des marches de hauteur variable sont principalement générées par les étapes de gravure donc en creux suivies d'un dépôt régulier. La réduction des dimensions des transistors nécessite d'aplanir ces reliefs, car ils peuvent provoquer des difficultés d'alignement (focalisation lors de la photolithographie), des problèmes de continuité de matériaux lors de dépôts ou des résidus de matériaux lors de la gravure de ces matériaux. Pour les technologies submicroniques, l'aplanissement est effectué principalement par polissage mécano-chimique des différentes couches déposées. L'épaisseur restant après polissage de ces dépôts isolants, semi-conducteurs ou conducteurs influe sur les caractéristiques électriques des circuits intégrés.

La fabrication des circuits intégrés s'effectue, à ce jour, sur des plaques d'un diamètre de 200 mm, avec 50 à 200 circuits par plaque suivant leur taille.

Les caractéristiques des circuits intégrés devant être reproduites quelles que soient leur position sur la plaque, l'uniformité des différentes étapes technologiques est essentielle. En particulier, une bonne uniformité de polissage mécano-chimique sur plaque permet d'éviter excès locaux de polissage de matériaux pouvant conduire à la destruction des circuits ou à des variations des caractéristiques électriques des circuits intégrés suivant leur position sur la plaque.

L'intégration croissante des circuits intégrés a donc nécessité le développement de nouvelles technologies telles que le polissage mécano-chimique appliqué à l'aplanissement de surfaces comportant des motifs en relief.

C'est pourquoi au cours des opérations de fabrication actuelle des circuits intégrés, on a besoin de polir principalement non plus seulement le silicium des plaques pour circuits intégrés, mais aussi d'autres composés des plaques à circuits intégrés comme l'oxyde de silicium et certains métaux tels que le tungstène. Les procédés de polissage de ces derniers matériaux sont bien maîtrisés.

Mais par contre les procédés de polissage mécano-chimique de matériaux semi-conducteurs tels que le silicium polycristallin, le silicium monocristallin épithaxié, le silicium amorphe ou de matériaux isolants tels que le verre de phosphosilicate (appelé plus communément PSG) ou le verre de borophosphosilicate (appelé plus communément BPSG) sont encore très mal maîtrisés à cause de l'inexistence d'abrasifs adaptés à ces différents matériaux.

Ces matériaux sont utilisés dans l'industrie microélectronique des semi-conducteurs en couches épitaxiées (silicium épitaxié) ou déposées (silicium polycristallin et amorphe, PSG et BPSG), à différents stades de la fabrication des circuits intégrés.

Le développement d'un abrasif spécifique au polissage de ces matériaux des plaques à circuits intégrés est donc fondamental pour la maîtrise de leurs procédés de polissage..

Dans la littérature, il a aussi été décrit le polissage de polysilicium par des suspensions aqueuses de silice colloïdale de pH basique, le plus souvent compris entre pH 9 et pH 12,5. Le pH de ces suspensions aqueuses de silice colloïdale a été rendu basique grâce à l'addition d'hydroxyde de métal alcalin tel que la soude ou la potasse, ou par l'addition d'une amine soluble dans l'eau (voir en particulier M.T. Bohr et al, WO-A-9627206, M. Motoshu et al, US-A-5.376.222, A.V. Gelatos et al, US-A-5.324.690, R.L. Lachapelle, US-A-3.328.141, S. Yamamichi et al, JP-A-07074313, M. Watanabe et al, JP-A-07249600).

L'utilisation de telles suspensions aqueuses basiques présente un certain nombre d'inconvénients. On obtient une mauvaise uniformité de polissage, en particulier sur les bords de la plaque à polir, appelée plus communément du terme anglais "wafer".

EP-A-0.745.656 décrit le polissage d'infimes isolants sur un substrat semi-conducteur en utilisant une composition abrasive contenant un mélange d'oxyde d'aluminium, de silice et d'oxyde de cérium en présence d'un agent stabilisant.

EP-A-0.363.100 décrit le polissage sélectif entre une surface comprenant $|Si_3N_4|$ et une surface plus facilement traitable que $|Si_3N_4|$ utilisant une silice colloïdale à 95,3% de pureté et exempte d'ammoniaque en raison des inconvénients introduits par cette dernière sur la sélectivité du polissage.

La demanderesse s'est donnée pour but principal, de mettre au point un procédé de polissage qui procure une amélioration de l'uniformité de polissage des couches des matériaux précédemment cités installées sur des plaques pour circuits intégrés, utilisés comme semi-conducteurs ou isolants dans la fabrication des circuits intégrés.

Il faut préciser que le polissage pourra être effectué sur pleine plaque (voir figures la et lb) ou sur plaque avec reliefs (voir figures lc et Id), afin d'aplanir ces reliefs.

Les matériaux concernés par l'invention intègrent comme on l'a vu ci-dessus, les matériaux à base de silicium ou à base de silicium dopé tels que le silicium polycristallin, le silicium épitaxié, le silicium amorphe, le verre de phosphosilicate, ou le verre de borophosphosilicate, ces deux derniers étant à base d'oxyde de silicium dopé, à l'exclusion du silicium initial utilisé lors de la fabrication des plaques pour circuits intégrés.

Pour réaliser toutes ces améliorations dans le polissage mécano-chimique des couches des matériaux ci-dessus, il a été constaté de façon surprenante et inattendue que l'utilisation d'une suspension de silice colloïdale, notamment d'une suspension comprenant des (ou de préférence essentiellement constituée de) fines particules individualisées de silice non liées entre elles par des liaisons siloxanes et utilisées en milieu neutre ou proche de la neutralité, permettait d'améliorer considérablement l'uniformité de polissage, tout en conservant une bonne vitesse d'attaque, ainsi que d'excellentes qualités d'aplanissement et de surfaces, en particulier la quasi absence de rugosité. Dans la présente demande et dans ce qui suit, l'on entend par « essentiellement» plus de 50%, notamment plus de 60%, particulièrement plus de 80%, plus particulièrement plus de 90%, tout particulièrement plus de 99%.

C'est pourquoi la présente invention a pour objet l'utilisation d'un abrasif qui comprend une suspension aqueuse à pH compris entre 6 et 8 contenant de préférence des particules de silice colloïdale individualisées, non liées entre elles par des liaisons siloxanes, pour le polissage mécano-chimique d'une couche de matériau semi-conducteur tel que le silicium polycristallin, le silicium monocristallin épitaxié, le silicium amorphe ou de matériau isolant tel que le verre de phosphosilicate ou le verre de borophosphosilicate utilisé lors de la fabrication des circuits intégrés, à l'exception du silicium initial utilisé lors de la fabrication des plaques pour circuits intégrés, ainsi qu'un procédé de polissage mécano-chimique d'une couche de matériau semi-conducteur tel que le silicium polycristallin, le silicium monocristallin épitaxié, le silicium amorphe ou de matériau isolant tels que le verre de phosphosilicate ou le verre de borophosphosilicate, utilisé dans l'industrie microélectronique des semi-conducteurs, à l'exception du silicium initial utilisé lors de la fabrication des plaques pour circuits intégrés, dans lequel l'on procède à une abrasion de la couche de matériau semi-conducteur ou de matériau isolant en frottant ladite couche à l'aide d'un tissu imprégné d'une composition abrasive, caractérisé en ce que l'abrasif comprend une suspension aqueuse à pH compris entre 6 et 8 de silice colloïdale de préférence comprenant des particules individualisées de silice colloïdale, non liées entre elles par des liaisons siloxanes, et de l'eau comme milieu de suspension. L'abrasif en question est notamment essentiellement constitué d'une telle suspension aqueuse à pH compris entre 6 et 8.

Ce polissage mécano-chimique peut intervenir à différentes étapes de la fabrication des circuits intégrés, notamment dans l'étape d'isolement latéral des transistors, dans la fabrication des grilles de transistors, dans la fabrication des interconnections diélectriques.

Ce polissage mécano-chimique peut aussi intervenir sur pleine plaque ou sur plaque avec reliefs, pour aplanir ces derniers.

Pour le polissage mécano-chimique des couches de matériaux à base de silicium, tel que le silicium polycristallin, le silicium épithaxié ou le silicium amorphe, ou à base d'oxyde de silicium dopé tel que le verre de phosphosilicate (ou PSG) ou le verre de borophosphosilicate (BPSG), les suspensions aqueuses de silice colloïdale utilisées possèdent de préférence des diamètres de particules individuelles compris entre 3 et 250 nm notamment entre 7 et 150 nm, particulièrement entre 10 et 100 nm.

Des suspensions aqueuses de silice colloïdale préférées selon l'invention sont obtenues, soit par neutralisation de sols de silice alcalins, en particulier, de sodium ou de potasium, par un acide tel que l'acide chlorhydrique, l'acide nitrique ou l'acide sulfurique, soit par neutralisation d'un d'un sol de silice acide par la soude, la potasse ou l'ammoniaque, de préférence par la potasse et l'ammoniaque, et tout particulièrement par l'ammoniaque.

On a pu noter que de telles suspensions de silice colloïdale, obtenues par neutralisation d'un sol acide par de l'ammoniaque à un pH de 8, donnaient un bon pourcentage d'uniformité, tout en conservant une bonne vitesse d'attaque du polysilicium, contrairement à ce qui a été indiqué dans EP-A-0.363.100.

Dans des conditions préférentielles de mise en oeuvre du procédé selon l'invention, on utilise des suspensions aqueuses à pH neutre ou compris entre 6 et 8, particulièrement entre 6,5 et 7,5.

Dans d'autres conditions préférentielles de mise en oeuvre du procédé selon l'invention, les diamètres des particules élémentaires des suspensions de silice colloïdale sont compris entre 3 et 250 nm, particulièrement entre 10 et 100 nm.

Dans encore d'autres conditions préférentielles de mise en oeuvre du procédé selon l'invention, la concentration pondérale en produit de polissage, c'est-à-dire de silice, est de 5 à 50 %, préférentiellement de 15 à 40 %.

Un avantage principal de l'invention est l'amélioration de l'uniformité du polissage mécano-chimique de couches de matériau semi-conducteur tel que le polysilicium (silicium polycristallin) ou des isolants à base d'oxyde de silicium dopé tel que le verre de boro phosphosilicate (BPSG) par utilisation de suspensions aqueuses de silice colloïdale à pH neutre ou proche de la neutralité.

Cette amélioration peut être par exemple essentiellement démontrée par des tests d'uniformité d'attaque du polissage tout en conservant une vitesse d'attaque du matériau semi-conducteur acceptable. Cette uniformité d'attaque du polissage représente la variation d'épaisseur de polysilicium sur une même plaque. Elle est calculée à partir de mesures de polysilicium sur une même plaque avant et après polissage (voir fig. la et fig. lb) selon la formule suivante :

$$U = \frac{\text{Epaisseur maxi - Epaisseur mini}}{2 \times \text{Epaisseur moyenne enlevée}} \times 100$$

Plus la valeur obtenue est basse, plus l'uniformité d'attaque est satisfaisante.

Un autre avantage de l'invention est que les suspensions aqueuses à pH compris entre 6 et 8 de silice colloïdale, notamment constituées de particules individualisées, non liées entre elles par des liaisons siloxanes, ont une très bonne stabilité dans le temps, d'où résulte l'absence de sédimentation des particules au cours du temps de stockage.

La présente demande a enfin pour objet un abrasif pour le polissage mécano-chimique d'une couche de matériau semi-conducteur à base de silicium tel que le silicium polycristallin, le silicium épitaxié ou le silicium amorphe ou des isolants à base d'oxyde de silicium dopé tel que le verre de phosphosilicate (PSG) ou le verre de borophosphosilicate (BPSG), à l'exception du silicium initial utilisé lors de la fabrication des plaques pour circuits intégrés, comprenant un tissu imprégné d'une composition liquide abrasive contenant une suspension aqueuse de silice colloïdale, comprenant des particules individualisées non liées entre elles par des liaisons siloxanes, de diamètre compris entre 3 et 250 nanomètres, de pH compris entre 6 et 8.

Des suspensions tout particulièrement préférées, développées par la Société CLARIANT (FRANCE) S.A., sont décrites ci-dessus dans les conditions opératoires du procédé.

Les exemples suivants permettront de mieux comprendre l'invention.

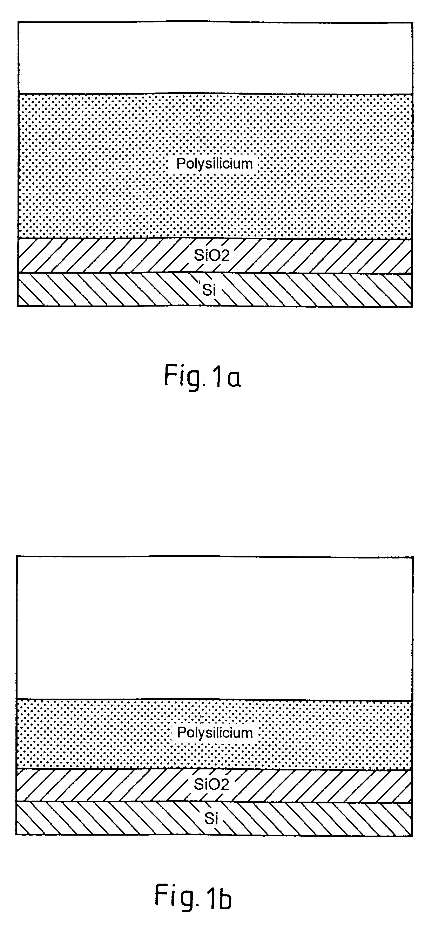

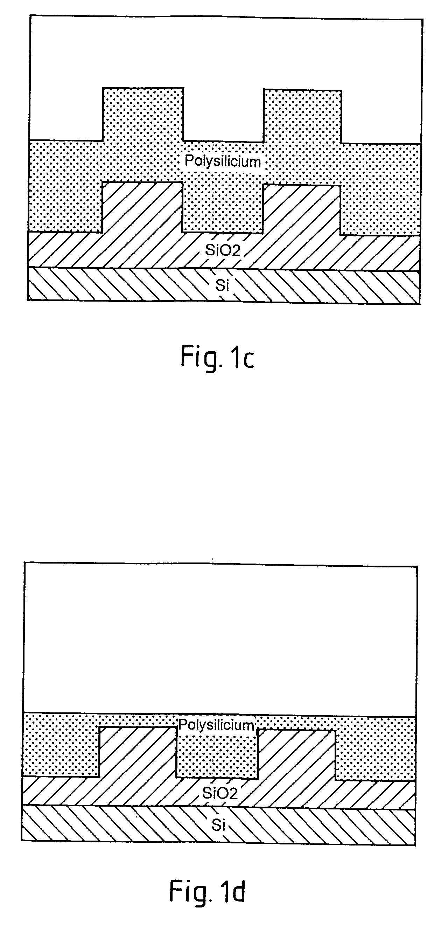

La figure la illustre l'état d'une pleine plaque revêtue de polysilicium avant polissage, tandis que la figure lb illustre l'état de cette plaque après polissage.

Les figures lc et ld illustrent l'état d'une plaque analogue mais avec reliefs. Ces reliefs ont été creusés par photolithogravure.

EXEMPLE 1:

Exemple de polissage avec des abrasifs à base de suspensions aqueuses à pH neutre de silice colloïdale.

Sur chaque plaquette étudiée est réalisé un dépôt de polysilicium d'environ 0,4 μm qui est mesuré avant et après polissage.

La plaquette est ensuite polie grâce au procédé standard suivant :

- force d'appui : 0,7 daN/cm$^2$
- vitesse de plateau : 40 tours/mn
- vitesse de tête (carrier) : 45 tours/mn
- température : 20°C
- débit d'abrasif: 50 cm$^3$ /mn
- tissu: IC 1400 sur Suba 4 de RODEL PRODUCTS

Avec une silice colloïdale dont les caractéristiques sont les suivantes :

- pH de la suspension aqueuse : 7
- diamètre moyen des particules élémentaires de silice colloïdale : 50 nm
- concentration pondérale en silice colloïdale : 30 %

On obtient :

- un pourcentage d'uniformité de 4 %.
- une vitesse d'attaque de polysilicium de 130 nm/mn (1300 Å/mn)

EXEMPLE 2

Exemples de polissage avec des abrasifs à base de suspensions aqueuses proches de la neutralité de silice colloïdale.

Dans les mêmes conditions que celles décrites dans l'exemple 1 en utilisant les mêmes silices colloïdales et en faisant varier seulement le pH on obtient les résultats suivants :

a) à pH 6

- un pourcentage d'uniformité de 4,6 %
- une vitesse d'attaque de polysilicium de 82 nm/mn (820 Å/mn)

b) à pH 8

- un pourcentage d'uniformité de 6 %
- une vitesse d'attaque du polysilicium de 195 nm/mn (1950 Å/mn)

EXEMPLE 3

Exemple de polissage de verre borophosphosilicate (BPSG) à une concentration de bore à 4,4% et de phosphore à 4,7% avec des abrasifs à base de suspensions aqueuses à pH neutre de silice colloïdale.
Dans les mêmes conditions que celles décrites dans l'exemple 1 en utilisant les mêmes silices colloïdales et en faisant varier seulement le pH on obtient les résultats suivants :

- un pourcentage de'uniformité de 3,9%
- une vitesse d'attaque de BPSG de 556 nm/mn (5560 Å/mn)

Expérimentation 1 :

Exemple de polissage avec des abrasifs à base de suspensions aqueuses basiques de silice colloïdale.
Dans les mêmes conditions que celles décrites dans l'exemple 1 en utilisant les mêmes silices colloïdales mais en les appliquant en milieu basique, on obtient les résultats suivants :

a) à pH 10

- un pourcentage d'uniformité de 18 %
- une vitesse d'attaque du polysilicium de 355 nm/mn (3550 Å/mn)

b) à pH 11

- un pourcentage d'uniformité de 30 %
- une vitesse d'attaque du polysilicium de 708,8 nm/mn (7088 Å/mn)

Expérimentation 2 :

Exemple de polissage avec des abrasifs à base de suspensions aqueuses acides de silice colloïdale.

Dans les mêmes conditions que celles décrites dans l'exemple 1 en utilisant les mêmes silices colloïdales mais en les appliquant en milieu acide à pH 2,2 on obtient les résultats suivants :

- un pourcentage d'uniformité de 8 %
- une vitesse d'attaque du polysilicium de 47 nm/mn (470 Å/mn)

Expérimentation 3:

Exemple de polissage de verre borophosphosilicate (BPSG) à une concentration de bore à 4,4% et de phosphore à 4,7% avec des abrasifs à base de suspensions aqueuses basiques de silice colloïdale.
Dans les mêmes conditions que celles décritesdans l'exemple 1 en utilisant les mêmes silices colloïdales mais en les appliquant en milieu basique à pH 10, on obtient les résultats suivants :

- un pourcentage d'uniformité de 12 %
- une vitesse d'attaque du BPSG de 45,1 nm/mn (451 Å/mn)

Expérimentation 4 :

Exemple de polissage de verre borophosphosilicate (BPSG) à une concentration de bore à 4,4% et de phosphore à 4,7% avec des abrasifs à base de suspensions aqueuses acidiques de silice colloïdale.
Dans les mêmes conditions que celles décritesdans l'exemple 1 en utilisant les mêmes silices colloïdales mais en les appliquant en milieu acide à pH 2,5, on obtient les résultats suivants :

- un pourcentage d'uniformité de 7,9 %
- une vitesse d'attaque du BPSG de 277 nm/mn (2770 Å/mn)

On constate donc que l'utilisation de suspensions de silice colloïdale à pH compris entre 6 et 8 permet d'obtenir une bonne uniformité de polissage tant sur le polysilicium que sur le BPSG tout en conservant une bonne vitesse d'attaque, un très bon état de surface de la plaque et un excellent aplanissement.

**Revendications**

1. Procédé de polissage mécano-chimique d'une couche de matériau semi-conducteur tel que le silicium polycristallin, le silicium monocristallin épitaxié, le silicium amorphe ou de matériau isolant tels que le verre de phosphosilicate ou le verre de borophosphosilicate utilisé dans l'industrie microélectronique des semi-conducteurs, à l'exception du silicium initial utilisé lors de la fabrication des plaques pour circuits intégrés, dans lequel l'on procède à une abrasion de la couche de matériau semi-conducteur ou de matériau isolant en frottant ladite couche à l'aide d'un tissu imprégné d'une composition abrasive, **caractérisé en ce que** l'abrasif comprend une suspension aqueuse à pH compris entre 6 et 8 de silice colloïdale qui comprend des particules de silice colloïdale individualisées, non liées entre elles par des liaisons siloxanes, et de l'eau comme milieu de suspension.

2. Procédé de polissage mécano-chimique selon la revendication 1, **caractérisé en ce que** l'abrasif est essentiellement constitué de ladite suspension aqueuse.

3. Procédé selon la revendication 2, **caractérisé par le fait que** ladite suspension aqueuse de silice colloïdale a un pH compris entre 6,5 et 7,5.

4. Procédé selon l'une quelconque des revendications 1 à 3, **caractérisé par le fait que** ladite suspension aqueuse de silice colloïdale comprend des particules individualisées de diamètre compris entre 3 et 250 nanomètres.

5. Procédé selon la revendication 4, **caractérisé par le fait que** ladite suspension aqueuse de silice colloïdale comprend des particules individualisées de silice colloïdale de diamètre compris entre 10 et 100 nanomètres.

6. Procédé selon l'une des revendications 1 à 5, **caractérisé par le fait que** ladite suspension aqueuse de silice colloïdale est utilisée à une concentration pondérale en silice comprise entre 5 et 50 %.

7. Procédé selon la revendication 6, **caractérisé par le fait que** ladite suspension aqueuse de silice colloïdale est utilisée à une concentration pondérale en silice comprise entre 15 et 40 %.

8. Procédé selon la revendication 7, **caractérisé par le fait que** la couche de matériau semi-conducteur est en silicium polycristallin.

9. Abrasif pour le polissage mécano-chimique d'une couche de matériau semi-conducteur à base de silicium tel que le silicium polycristallin, le silicium épitaxié ou le silicium amorphe ou à base d'oxyde de silicium dopé tel que le verre de phosphosilicate (PSG) ou le verre de borophosphosilicate (BPSG), comprenant un tissu imprégné d'une composition liquide abrasive contenant une suspension aqueuse de silice colloïdale comprenant des particules individualisées non liées entre elles par des liaisons siloxanes, de diamètre compris entre 3 et 250 nanomètres, de pH compris entre 6 et 8.

**Patentansprüche**

1. Verfahren zum chemisch-mechanischen Polieren einer Schicht aus Halbleitermaterial, wie etwa polykristallinem Silicium, epitaktischem monokristallinem Silicium, amorphem Silicium, oder aus Nichtleitermaterial, wie etwa Phosphorsilikatglas oder Borphosphorsilikatglas, das in der mikroelektronischen Halbleiterindustrie verwendet wird, mit Ausnahme des anfänglichen Siliciums, das bei der Herstellung von Scheiben für integrierte Schaltungen verwendet wird, bei dem eine Abrasion der Halbleitermaterialschicht oder der Nichtleitermaterialschicht durchgeführt wird, indem die Schicht mit Hilfe eines Gewebes, das mit einer abrasiven Zusammensetzung getränkt ist, abgerieben wird, **dadurch gekennzeichnet, dass** das Abrasivmittel eine wässrige Suspension kolloidalen Siliciumdioxids umfasst, die einzelne Partikel kolloidalen Siliciumdioxids, die nicht durch Siloxanbindungen aneinander gebunden sind, und Wasser als Suspensionsmittel enthält, wobei der pH-Wert zwischen 6 und 8 enthalten ist.

2. Verfahren zum chemisch-mechanischen Polieren nach Anspruch 1, **dadurch gekennzeichnet, dass** das Abrasivmittel im Wesentlichen aus der wässrigen Suspension besteht.

3. Verfahren nach Anspruch 2, **dadurch gekennzeichnet, dass** die wässrige Suspension kolloidalen Siliciumdioxids einen pH-Wert, der zwischen 6,5 und 7,5 enthalten ist, aufweist.

4. Verfahren nach einem der Ansprüche 1 bis 3, **dadurch gekennzeichnet, dass** die wässrige Suspension kolloidalen Siliciumdioxids einzelne Partikel mit einem Durchmesser umfasst, der zwischen 3 und 250 Nanometern enthalten ist.

5. Verfahren nach Anspruch 4, **dadurch gekennzeichnet, dass** die wässrige Suspension kolloidalen Siliciumdioxids einzelne Partikel kolloidalen Siliciumdioxids mit einem Durchmesser, der zwischen 10 und 100 Nanometern enthalten ist, umfasst.

6. Verfahren nach einem der Ansprüche 1 bis 5, **dadurch gekennzeichnet, dass** die wässrige Suspension kolloidalen Siliciumdioxids mit einer Gewichtskonzentration an Siliciumdioxid, die zwischen 5 und 50 % enthalten ist, verwendet wird.

7. Verfahren nach Anspruch 6, **dadurch gekennzeichnet, dass** die wässrige Suspension kolloidalen Siliciumdioxids mit einer Gewichtskonzentration an Siliciumdioxid, die zwischen 15 und 40 % enthalten ist, verwendet wird.

**8.** Verfahren nach Anspruch 7, **dadurch gekennzeichnet, dass** die Halbleitermaterialschicht aus polykristallinem Silicium ist.

**9.** Abrasivmittel zum chemisch-mechanischen Polieren einer Schicht aus Halbleitermaterial auf der Basis von Silicium, wie etwa polykristallinem Silicium, epitaktischem Silicium oder amorphem Silicium, oder auf der Basis dotierten Siliciumoxids, wie etwa Phosphorsilikatglas (PSG) oder Borphosphorsilikatglas (BPSG), ein Gewebe umfassend, das mit einer abrasiven flüssigen Zusammensetzung getränkt ist, die eine wässrige Suspension kolloidalen Siliciumdioxids enthält, die einzelne, nicht durch Siloxanbindungen aneinander gebundene Partikel mit einem Durchmesser zwischen 3 und 250 Nanometern aufweist, wobei der pH-Wert zwischen 6 und 8 enthalten ist.

**Claims**

**1.** Method for the chemical-mechanical polishing of a layer of semiconductor material, such as polycrystalline silicon, epitaxial single-crystal silicon or amorphous silicon, or of an insulating material, such as phosphosilicate glass or borophosphosilicate glass, used in the microelectronics semiconductor industry, with the exception of the initial silicon used during the fabrication of wafers for integrated circuits, in which method the layer of semiconductor material or insulating material is abraded by rubbing the said layer using a cloth impregnated with an abrasive composition, **characterized in that** the abrasive comprises an aqueous colloidal silica suspension of pH between 6 and 8, which comprises individual colloidal silica particles, not bonded together by siloxane bonds, and water as suspension medium.

**2.** Chemical-mechanical polishing method according to Claim 1, **characterized in that** the abrasive essentially consists of the said aqueous suspension.

**3.** Method according to Claim 2, **characterized in that** the said aqueous colloidal silica suspension has a pH of between 6.5 and 7.5.

**4.** Method according to any one of Claims 1 to 3, **characterized in that** the said aqueous colloidal silica suspension comprises individual particles having a diameter of between 3 and 250 nanometres.

**5.** Method according to Claim 4, **characterized in that** the said aqueous colloidal silica suspension comprises individual particles of colloidal silica having a diameter of between 10 and 100 nanometers.

**6.** Method according to one of Claims 1 to 5, **characterized in that** the said aqueous colloidal silica suspension is used with a silica weight concentration of between 5 and 50%.

**7.** Method according to Claim 6, **characterized in that** the said aqueous colloidal silica suspension is used with a silica weight concentration of between 15 and 40%.

**8.** Method according to Claim 7, **characterized in that** the layer of semiconductor material is made of polycrystalline silicon.

**9.** Abrasive for the chemical-mechanical polishing of a layer of semiconductor material based on silicon, such as polycrystalline silicon, epitaxial silicon or amorphous silicon, or based on doped silicon oxide, such as phosphosilicate glass (PSG) or borophosphosilicate glass (BPSG), comprising a cloth impregnated with an abrasive liquid composition containing an aqueous colloidal silica suspension, comprising individual particles that are not bonded together by siloxane bonds and have a diameter of between 3 and 250 nanometres, and having a pH of between 6 and 8.

Polysilicium

SiO2

Si

Fig. 1a

Polysilicium

SiO2

Si

Fig. 1b

Fig. 1c

Fig. 1d